# EUROPEAN PATENT APPLICATION

(11) **EP 2 608 211 A1**
(43) Date of publication of application: **26.06.2013**
(21) Application number: 11195106.7
(22) Date of filing: 22.12.2011
(51) Int. Cl.: G11C 29/08, G06F 11/10

(54) **Method of testing a flash memory**

(71) Applicant: Fluiditech IP Limited, Victoria, Mahe (SC)
(72) Inventor: Chu, Yung-Chiang, 115 Taipei City (TW)
(74) Representative: Pallini, Diego

(57) **Abstract**

A method of testing a flash memory is applied to retrieve the flash memory available by picking up a defective flash memory. The flash memory includes at least a block, a page, and a cell. The method comprises inputting a test command into the flash memory to execute at least one of write, read, or compare of the flash memory. After the test command is executed, the states of the block, page, and cell in the flash memory may be obtained. The states are marked in a flash memory distribution list to allow a controller to access at least one of the normal block, page, and cell from the list. Thus, in the method, the normal block, page, and cell may be obtained.

## Description

### FIELD OF THE INVENTION

This invention relates to a method of testing a flash memory and particularly to a method of picking up a defective flash memory to recycle and retrieve for a useful flash memory.

### BACKGROUND OF THE INVENTION

Generally, due to the aging, deteriorating, and damage of a flash memory provided with a memory area that comprises a block, a page, and a cell that is used for a length of time, an electronic device with the flash memory couldn't operate.

For example, when having been used for 2 or 3 years long, the electronic product provided with the flash memory, such as Smartphone, Digital Still Camera, memory card and the like might be defective or return to its original manufacturer through a recovery system. The conventional electronic product is then decomposed by the original manufacturer, and, for example, its LCD panel, PCB, and flash memory, such as NAND that still function are retrieved and next assembled, tested, and packaged for becoming a brand new or new low-end electronic product and then selling it. However, after, for example, the flash memory, is recovered, only part of the memory area might function; for example, after the original 64G flash memory is used for a length of time, 10G memory area is damaged and thus the 64G flash memory cannot be fully available, thereby the flash memory being discarded.

Thus, in the method of testing the flash memory according to this invention, the original 64G flash memory that is recovered may be picked, detected, and processed in a reconfiguration procedure for forming a standard or non-standard, for example, 32G, 16G, 8G, 4G, 2G, or 1G flash memory that is available, reducing the cost and achieving the environment protection.

Consequently, because of the technical defects of described above, the applicant keeps on carving unflaggingly through wholehearted experience and research to develop the present invention, which can effectively improve the defects described above.

### SUMMARY OF THE INVENTION

The object of the present invention is to provide a method of testing a flash memory, in which a flash memory is picked, detected, and processed to recover a memory area, such as a memory block, a memory page, and a memory cell, which may still function, in the flash memory through a test.

In order to achieve the object, the method of testing the flash memory according to this invention is applied to retrieve the flash memory available by picking up a defective flash memory. The flash memory comprises at least a block, a page, and a cell. The method comprises step (a) of inputting a test command into the flash memory to at least write, read, or compare the flash memory; step (b) of getting at least one of the block, page, and cell working in a normal or abnormal state after executing the test command; step (c) of marking at least one of the block, page, and cell in a distribution list of flash memory; and step (d) using at least one of the block, page, and cell marked as the normal state according to the flash memory distribution list.

Compared with the prior art, the method of testing the flash memory according to this invention may be used to retrieve a memory area available from the partially defective flash memory that cannot be used in the prior art by means of reconfiguration and control in the procedures of picking, detection, and processing for achievement of environment protection and cost down.

Further, in the method according to this invention, the states of the block, page, cell in the flash memory that is picked, detected, and processed may also be provided for a memory control unit in an external electronic device so that the memory control unit may be allowed to do dynamic adjustment and configuration depending upon the states of flash memory for extending the service life of flash memory and increasing the stability of operation of the electronic device and the safety of data storage. The method according to this invention may be implemented merely in the sleep mode of the electronic device or may be implemented when the electronic device accesses data. For example, when the flash memory gives a programmable command through a host or controller for programming or reading data, the method according to this invention may be used to monitor Error Correcting Codes of the flash memory, dynamically allowing the normal memory area to be accessed by the host or controller.

Further, the method according to this invention may prevent the flash memory from being impacted by an electrical environment, such as the impact of leakage current.

Next, in the method according to this invention, more than two time of determination may be implemented; thus, although the memory area with block, page, and cell is determined to be normal in a previous time, owing to the neighboring abnormal memory area, the method is used to retest the normal memory area, preventing the normal memory area from being interfered and impacted by the abnormal memory area and then staying in an abnormal state.

### BRIEF DESCRIPTION OF THE DRAWINGS

Fig. 1 is a flow chart of a method of testing a flash memory in a first embodiment of this invention;
Fig. 2 is a schematic view illustrating the structure of flash memory of Fig. 1;
Fig. 3 is a schematic view illustrating a state of the reset flash memory of Fig. 1;

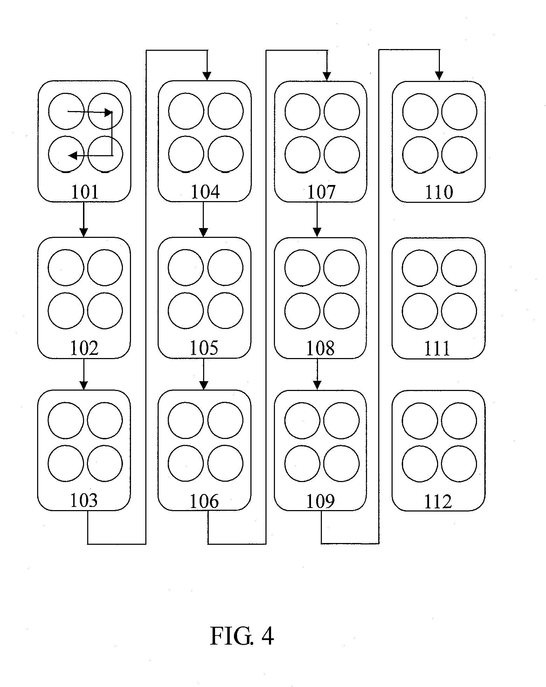

Fig. 4 is a schematic view illustrating a state of the sequentially tested flash memory of Fig. 1;
Fig. 5 is a schematic view illustrating a state of the randomly tested flash memory of Fig. 1;
Fig. 6 is a flow chart of the method of testing the flash memory in a second embodiment of this invention;
Fig. 7 is a flow chart of the method of testing the flash memory in a third embodiment of this invention;
Fig. 8 is a flow chart of the method of testing the flash memory in a fourth embodiment of this invention;
Fig. 9 is a flow chart of the method of testing the flash memory in a fifth embodiment of this invention;
Fig. 10 is a flow chart of the method of testing the flash memory in a sixth embodiment of this invention;
Fig. 11 is a structural schematic view illustrating the method of testing the flash memory of Fig. 10;
Fig. 12 is a flow chart of the method of testing the flash memory in a seventh embodiment of this invention;
Fig. 13 is a structural schematic view illustrating the method of testing the flash memory of Fig. 12;
Fig. 14 is a flow chart of the method of testing the flash memory in an eighth embodiment of this invention; and
Fig. 15 is a flow chart of the method of testing the flash memory in a ninth embodiment of this invention.

### DETAILED DESCRIPTION OF THE PREFERRED EMBODIMENTS

Now, the present invention will be described more specifically with reference to the following embodiments. It is to be noted that the following descriptions of preferred embodiments of this invention are presented herein for purpose of illustration and description only; it is not intended to be exhaustive or to be limited to the precise form disclosed.

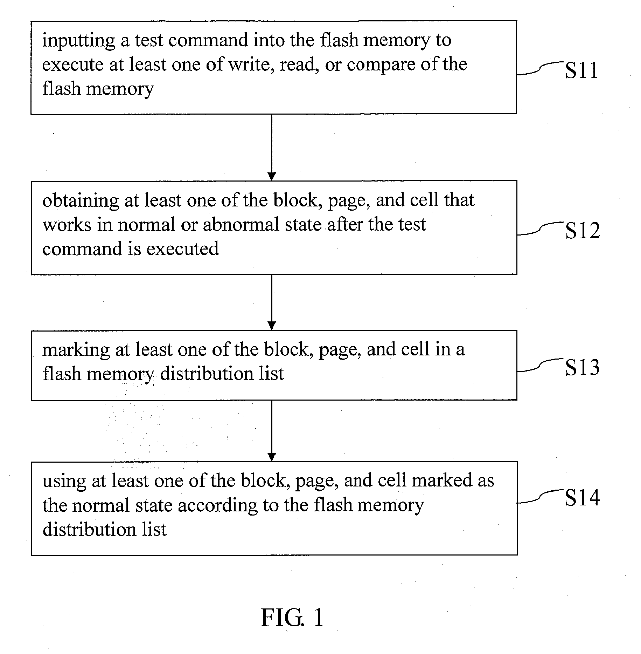

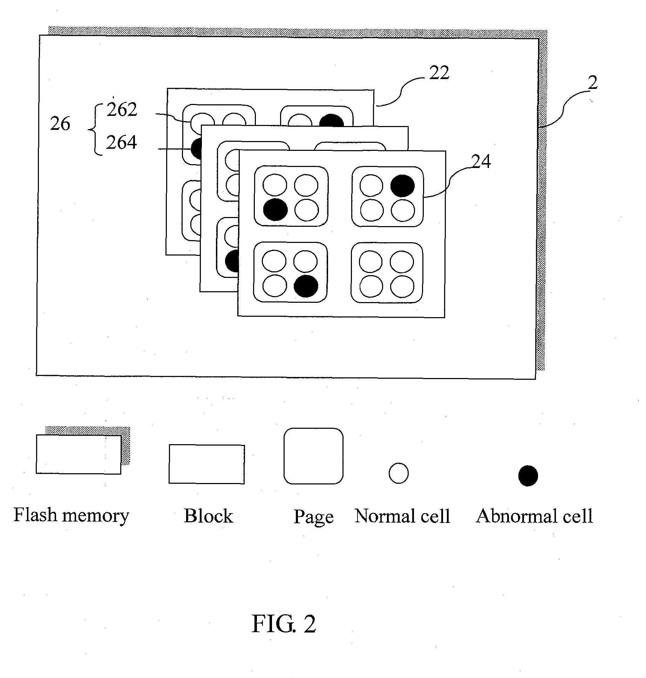

Refer to Fig. 1 as a flow chart of a method of testing a flash memory in a first embodiment of this invention. In Fig. 1, the method of testing the flash memory according to this invention is applied to retrieve the flash memory available by picking up a defective flash memory. The flash memory 2 comprises at least a block 22, a page 24, and a cell 26 as a memory area. The cell 26 further comprises normal cells and abnormal cells, as shown in Fig. 2. Further, it is defined data may be normally accessed from the normal cell 262; on the contrary, it is defined that data cannot be accessed from the abnormal cell 264.

The method of testing the flash memory starts from step S11 of inputting a test command (TC) into the flash memory 2 for at least writing to, reading from, or comparing with the flash memory 2; for example, the test command may be an ERASE command. In an embodiment, the flash memory 2 may reconfigure the block 22, the page 24, and the cell 22 according to the TC for a state of default value; for example, the default value may be 0xFF.

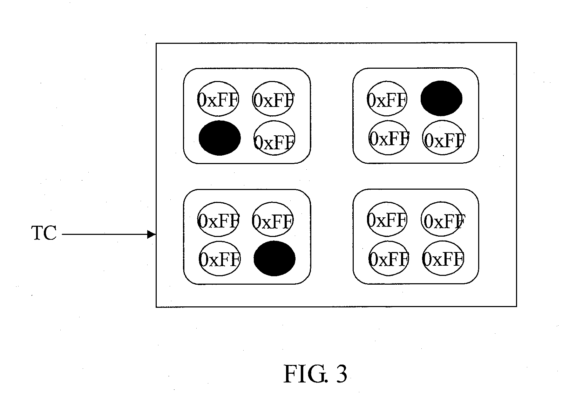

For example, together with reference to Fig. 3, after the flash memory 2 receives the TC, such as the ERASE command, the content in the normal cell 262 of page 24 in the block in the flash memory 2 is reset to 0xFF, while the content in the abnormal cell 264 is not reset to 0xFF.

Further, in step S12, after the test command is executed, at least one of the block 22, page 24, and cell 26 that works in normal or abnormal state is obtained. In other word, by detecting the states of block 22, page 24, and cell 26, it is determined whether the memory area is normal or abnormal.

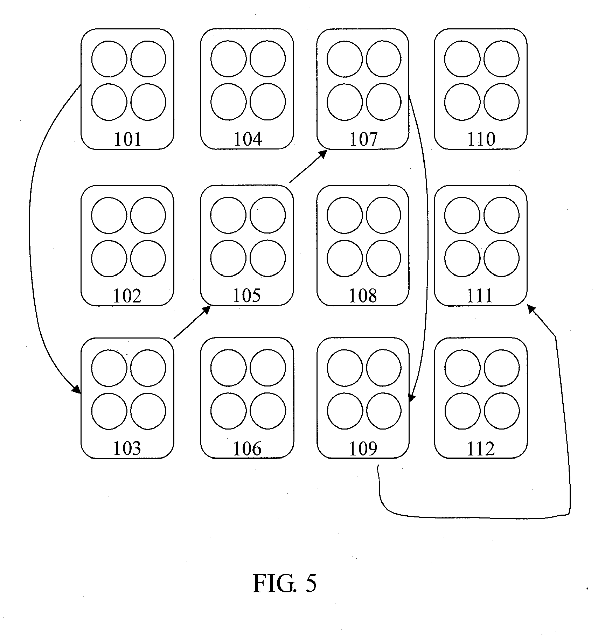

Next, step S12 may comprise getting at least one of the states of the block 22, page 24, and cell 26 in a sequential or random manner. In the sequential manner, sequential detection may be implemented starting from the memory area 101 in the order of arrangement of the memory areas 101-112 in the flash memory 2. Then, the memory area 102 is detected until the memory area 112 detection is completed to get the state of memory area, as shown in Fig, 4. Further, in the random manner, when the flash memory 2 works in a specific behavior or pattern, a specific path may be used to get the state of memory area; for example, the detection path may detect the states of odd memory areas 101, 103, and 105, as shown in Fig. 5.

For example as mentioned above, in step S12, one of the states of the block 22, page 24, and cell 26 may be compared with the default value to generate a result; namely, after the ERASE command is received, the cell 26 is reset to 0xFF and detected to determine whether the content is 0xFF or not, which may be used to determine whether the cell 26 is the normal cell 262 or the abnormal cell 264.

Next, in step S 13, at least one of the block 22, page 24, and cell 26 is marked in a flash memory distribution list. In other words, after step S12, determination may be made whether the cell 26 is the normal cell 262 or the abnormal cell 264 and the normal cell 262 and the abnormal cell 262 are separately marked in the flash memory distribution list.

Then, in step S 14, at least one of the block, page, and cell marked as the normal state according to the flash memory distribution list is used. In other words, an external controller or host may read the normal memory area from the flash memory distribution list, being prevented from reading the abnormal memory area.

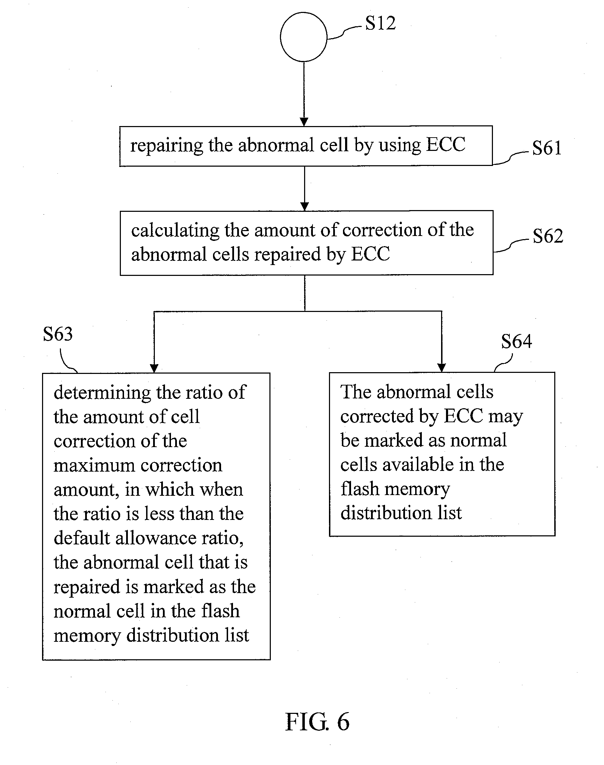

Refer to Fig. 6 as a flow chart of the method of testing the flash memory in a second embodiment of this invention. In Fig. 6, after step S12, the method of testing the flash memory may further comprise step S61 of repairing the abnormal cell by means of Error Correcting Codes (ECC). The ECC allows the maximum amount of correction for repairing the cell.

Then, in step S62, the amount of correction of the abnormal cell repaired by ECC is calculated.

After steps S61 and S62, the method further comprises step S63 of determining the ratio of the amount of cell correction of the maximum correction amount, and thus when the ratio is less than the default allowance ratio, the abnormal cell that is repaired is marked as the normal cell in the flash memory distribution list. The default allowance value is 50%; namely, the amount of corrected cell occupies the ration of half the maximum amount of cell correction allowed by ECC. In this example, if the maximum correction amount is 48 and, after calculation, the amount of abnormal cells that must be corrected is 24, then when the amount of cells that must be corrected is less than half the amount of maximum correction, the abnormal cells corrected by ECC may be marked as normal cells available in the flash memory distribution list.

If the state is in step S63, step S64 runs, which indicates that when the ratio is less than the default allowance ratio, the abnormal cell that is repaired is kept and marked as the abnormal cell in the flash memory distribution list. Because the amount of abnormal cells that must be corrected in step S64 is larger than the default allowance ratio, although the abnormal cells may be still corrected by ECC, for assurance of stability and accuracy of transfer and access of the data from the whole flash memory, in this step, the cells are still marked as abnormal cells in the list.

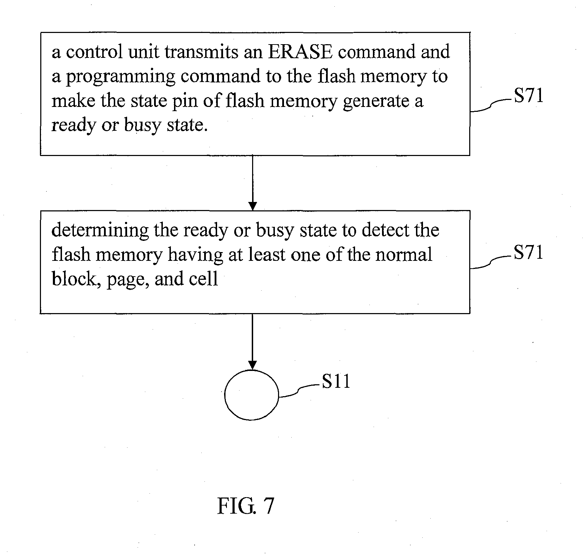

Refer to Fig. 7 as a flow chart of the method of testing the flash memory in a third embodiment of this invention. In Fig. 7, before step S11, the method may further comprise step S71 in which a control unit transmits the ERASE command the programming command to the flash memory 2 and thus the state pin, such as the R/B pin of flash memory 2 generates a ready or busy state. In another embodiment, the control unit transmits the ERASE command and the programming command to the flash memory 2 to generate a corresponding address state in the I/O state pin of the flash memory 2.

Next, in step S72, the ready or busy state is determined to detect the flash memory 2 having at least one of the normal block 22, page 24, and cell 26.

According to a report given in step S72, steps S11 through S 14 are next implemented so that the a second accurate determination of the flash memory 2 may be made in the manners of write, read, and comparison and the result given from a test implemented by the control unit in steps S71 and S72 may be concrete.

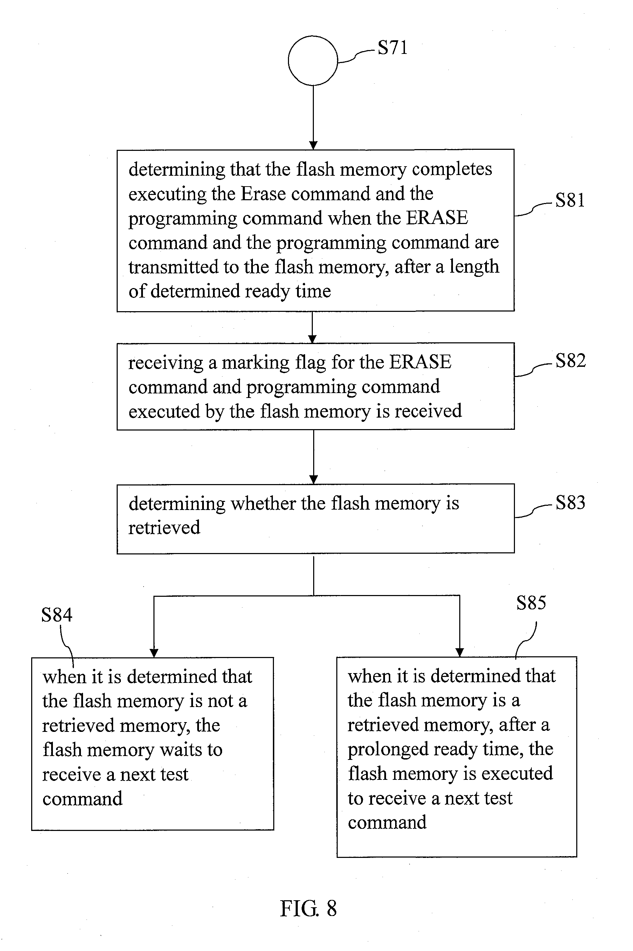

Refer to Fig. 8 as a flow chart of the method of testing the flash memory in a fourth embodiment of this invention. In Fig. 8, beside much the same steps implemented in the embodiment mentioned above, after step S71, step S81 is implemented, in which when the ERASE command and the programming command are transmitted to the flash memory, after a length of determined ready time, determination is made that the flash memory completes executing the Erase command and the programming command; for example, after several seconds or several ten seconds of determined ready time, determination is made that there may be enough time for testing the flash memory by using the commands.

Next, in step S82, a marking flag for the ERASE command and programming command executed by the flash memory is received. Then, in step S83, according to the marking flag, whether the flash memory is retrieved is further determined for going on to implement steps S84 and S85. In step S84, when it is determined that the flash memory is not a retrieved memory, the flash memory waits to receive a next test command. And, in step S85, when it is determined that the flash memory is a retrieved memory, after a prolonged ready time, the flash memory is executed to receive a next test command. In other words, if the flash memory is a retrieved one, extra adequate prolonged ready time is given to wait for an accurate test result.

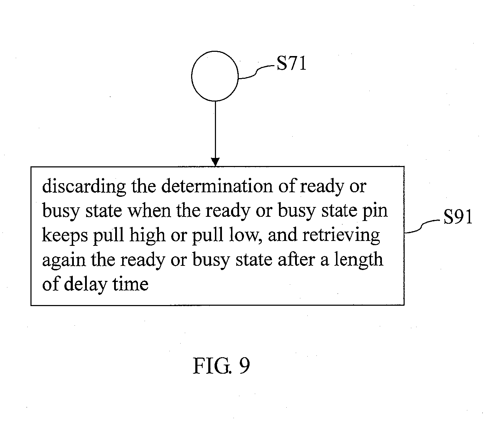

Refer to Fig. 9 as a flow chart of the method of testing the flash memory in a fifth embodiment of this invention. With reference to Fig. 9, after step S71, the method may further comprise step S91 in which after it is determined that after the control unit transmits the ERASE command and the programming command to the flash memory 2, when the state pin of flash memory 2, such as R/B or I/O port keeps pull high or pull low, the determination of ready or busy state is discarded and, after a length of delay time, the ready or busy state is retrieved again.

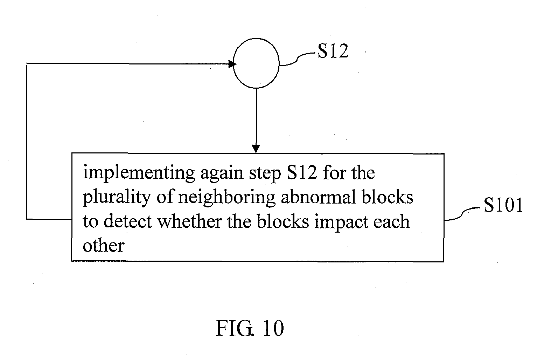

Refer to Fig. 10 as a flow chart of the method of testing the flash memory in a sixth embodiment of this invention. In Fig. 10, after step S12, the method further comprise step S101 in which step S12 is implemented again for the plurality of neighboring abnormal blocks to detect whether the blocks impact each other.

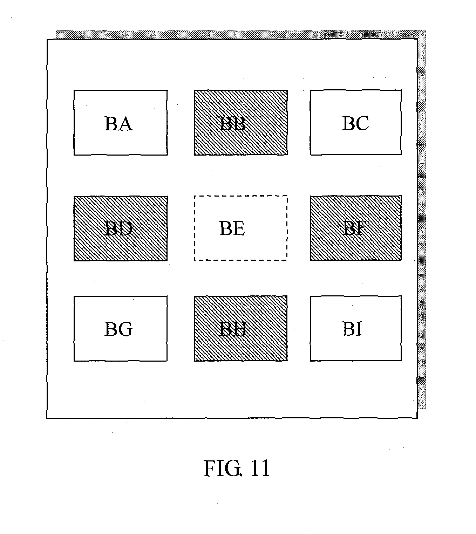

For example, with reference to Fig. 11, there are blocks BA-BI. When it is detected that the block BE is abnormal, the blocks BB, BD, BH, and BF adjacent to the block BE is determined again. The blocks BB, BD, BH, and BF are determined possibly to be normal in a previous determination.

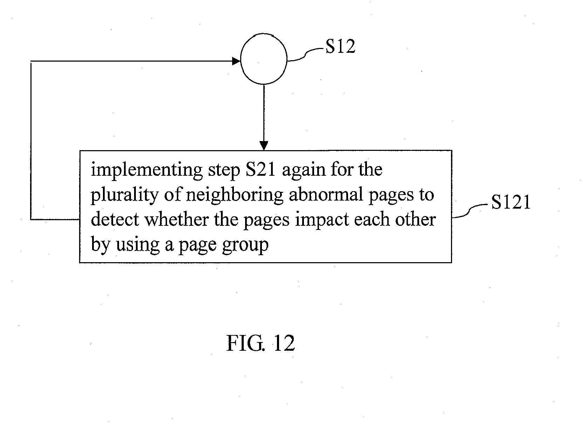

Refer to Fig. 12 as a flow chart of the method of testing the flash memory in a seventh embodiment of this invention. In Fig. 12, after step S12, the method further comprise step S121 in which step S12 is implemented again for the plurality of neighboring abnormal pages to detect whether the pages impact each other by using a page group.

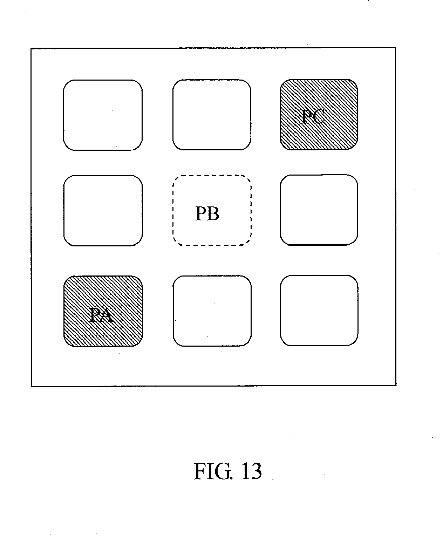

For example, with reference to Fig. 13, there are pages BA-BI. When it is detected that the page PB is abnormal, the page group, for example, PA, PB, and PC that are defined to be the page group, is used to determine the page PB is in the group of the pages PA and PC. The pages PA and PC are determined possibly to be normal in a previous determination.

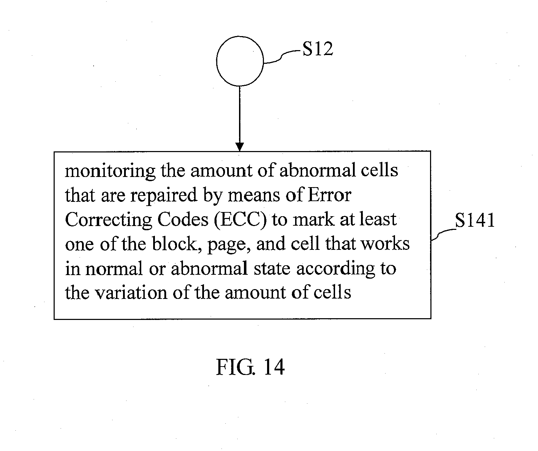

Refer to Fig. 14 as a flow chart of the method of testing the flash memory in an eighth embodiment of this invention. In Fig. 14, after step S12, the method of testing the flash memory may further comprise step S 141 of monitoring the amount of abnormal cells that are repaired by means of Error Correcting Codes (ECC). According to the variation of the amount of cells, at least one of the block, page, and cell that work in normal or abnormal state is marked. In other words, when the command read is executed, the amount of cells corrected by the ECC may be monitored to determine whether a normal state happens; for example, the amount of correction each time is erratic. If an abnormal state happens, there are instable block, page, and cell in the flash memory.

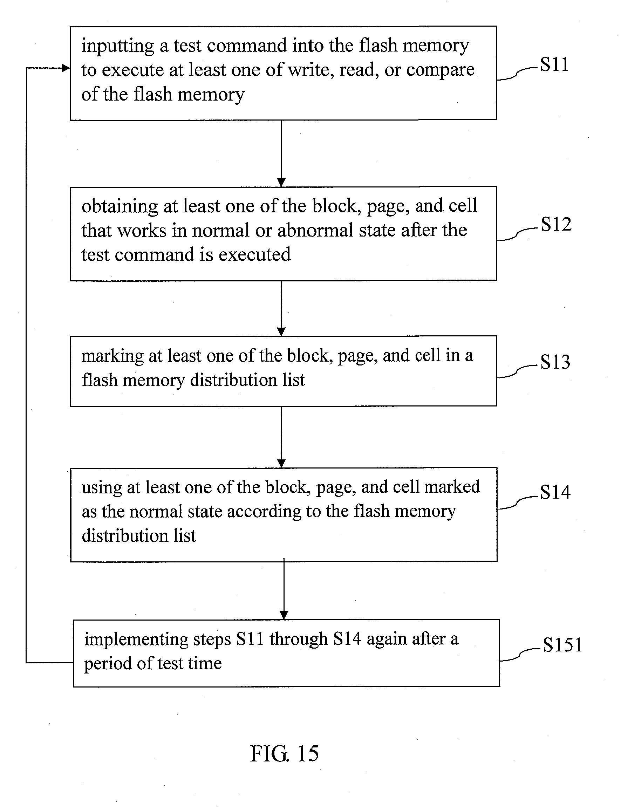

Refer to Fig. 15 as a flow chart of the method of testing the flash memory in a ninth embodiment of this invention. In Fig. 15, after step S 14, the method of testing the flash memory comprises step S151 of implementing steps S11 through S 14 again after a period of test time, preventing at least one of the block, page, and cell marked as normal state from becoming abnormal state due to current leakage.

## Claims

1. A method of testing a flash memory, being applied to retrieve the flash memory available by picking up a defective flash memory, the flash memory comprising a block, a page, and a cell, the method comprising:
a. inputting a test command into the flash memory to execute at least one of write, read, or compare of the flash memory;
b. obtaining at least one of the block, page, and cell that works in normal or abnormal state after the test command is executed;
c. marking at least one of the block, page, and cell in a flash memory distribution list; and
d. using at least one of the block, page, and cell marked as the normal state according to the flash memory distribution list.

2. The method of testing the flash memory according to claim 1, wherein step (a) comprises reconfiguring at least one of the block, page, and cell according to the TC for a state of default value.

3. The method of testing the flash memory according to claim 2, wherein step (b) comprises comparing at least one of the states of the block, page, and cell with the default value to generate a result.

4. The method of testing the flash memory according to claim 3, wherein step (c) comprises marking at least one of the block, page, and cell according to the compare result; optionally
wherein the test command is an ERASE command; wherein optionally the determined value is 0xFF.

5. The method of testing the flash memory according to claim 1 or 2, wherein step (b) comprises getting at least one of the states of the block, page, and cell in a sequential or random manner.

6. The method of testing the flash memory according to claim 1, wherein, after step (b), the method comprises:
e. repairing the abnormal cell by means of Error Correcting Codes (ECC), in which the ECC allows the maximum amount of correction for repairing the cell; and
f. calculating the amount of correction of the abnormal cells repaired by ECC.

7. The method of testing the flash memory according to claim 6, wherein, after step (f), the method comprises:
determining the ratio of the amount of cell correction of the maximum correction amount, in which when the ratio is less than the default allowance ratio, the abnormal cell that is repaired is marked as the normal cell in the flash memory distribution list; or wherein, after step (g), the method comprises:
h. keeping the abnormal cell that is repaired and marking it as the abnormal cell in the flash memory distribution list when the ratio is less than the default allowance ratio.

8. The method of testing the flash memory according to claim 7, wherein the determined value is 50%.

9. The method of testing the flash memory according to claim 1, wherein, before step (a), the method comprises:
i. a control unit transmitting an ERASE command and a programming command to the flash memory to make the state pin of flash memory generate a ready or busy state; and
j. determining the ready or busy state to detect the flash memory having at least one of the normal block, page, and cell.

10. The method of testing the flash memory according to claim 9, wherein the step (i) further comprises, when the ERASE command and the programming command are transmitted to the flash memory, after a length of determined ready time, determining that the flash memory completes executing the Erase command and the programming command.

11. The method of testing the flash memory according to claim 10, wherein the method further comprises:
k. receiving a marking flag for the ERASE command and programming command executed by the flash memory is received; and
1. further determining whether the flash memory is retrieved according to the marking flag; optionally
wherein, after step (1), the method comprises executing the flash memory to receive a next test command when it is determined that the flash memory is a retrieved memory, after a prolonged ready time.

12. The method of testing the flash memory according to claim 9, wherein step (i) comprises discarding the determination of ready or busy state when the ready or busy state pin keeps pull high or pull low, and retrieving again the ready or busy state after a length of delay time.

13. The method of testing the flash memory according to claim 1, wherein, after step (b), the method further comprises:
m. implementing again step (b) for the plurality of neighboring abnormal blocks to detect whether the blocks impact each other; or
wherein, after step (b), the method further comprises:
n. implementing step (b) again for the plurality of neighboring abnormal pages to detect whether the pages impact each other by using a page group.

14. The method of testing the flash memory according to claim 1, wherein, before step (a), the method comprises:
o. determining whether the transmission port gets error data from the page according to the pull-high or pull-low state of transmission port of the flash memory.

15. The method of testing the flash memory according to claim 1, wherein, after step (b), the method comprises:
p. monitoring the amount of abnormal cells that are repaired by means of Error Correcting Codes (ECC) to mark at least one of the block, page, and cell that works in normal or abnormal state according to the variation of the amount of cells; or
wherein, after step (d), the method comprises:
q. implementing steps (a) through (d) again after a period of test time to prevent at least one of the block, page, and cell marked as normal state from becoming abnormal state due to current leakage.
